# EUROPÄISCHE PATENTSCHRIFT

(11) **EP 1 614 333 B1**
(45) Veröffentlichungstag und Bekanntmachung des Hinweises auf die Patenterteilung: **04.10.2006**
(21) Anmeldenummer: 04731358.0
(22) Anmeldetag: 06.05.2004
(51) Int. Cl.: H05K 7/20

(54) **KÜHLUNGSSYSTEM FÜR GERÄTE- UND NETZWERKSCHRÄNKE UND VERFAHREN ZUR KÜHLUNG VON GERÄTE- UND NETZWERKSCHRÄNKEN**
COOLING SYSTEM FOR EQUIPMENT AND WIRING CABINETS AND METHOD FOR COOLING EQUIPMENT AND WIRING CABINETS
SYSTEME DE REFROIDISSEMENT POUR ARMOIRES D'INSTRUMENTS ET ARMOIRES RESEAU, ET PROCEDE POUR REFROIDIR DES ARMOIRES D'INSTRUMENTS ET ARMOIRES RESEAU

(30) Priorität: 26.04.2004 DE 202004006552 U
(43) Veröffentlichungstag der Anmeldung: 11.01.2006
(73) Patentinhaber: Knürr AG, 94424 Arnstorf (DE)
(72) Erfinder: EBERMANN, Heiko, 01109 Dresden (DE)
(74) Vertreter: Heim, Hans-Karl
(86) Internationale Anmeldenummer: PCT/EP2004/004854
(87) Internationale Veröffentlichungsnummer: WO 2005/104642

(56) Entgegenhaltungen:
- WO-A-03/005791
- DE-A1- 2 152 541
- DE-A1- 2 537 295
- DE-A1- 10 128 367
- DE-A1- 10 210 417
- US-A1- 2001 029 163
- US-A1- 2003 150 231

## Beschreibung

Die Erfindung betrifft ein Kühlungssystem für Geräte- und Netzwerkschränke, insbesondere Serverschränke, gemäß dem Oberbegriff des Anspruchs 1 und ein Verfahren zur Kühlung von Geräte- und Netzwerkschränken gemäß dem Oberbegriff des Anspruchs 17.

Aus DE-A 2 152 541 ist ein modulares elektronisches System mit einer Anzahl hintereinander geschichteter elektronischer Schaltungseinheiten und Hohlräumen zwischen den einzelnen Schaltungseinheiten sowie beidseitig dieser Schaltungseinheiten bekannt. Eine frontseitige und rückseitige Halterungsplatte und eine Befestigungseinrichtung spannt die hintereinander geschichteten Schaltungseinheiten und Halterungsplatten zu einem Stapel zusammen. Ein Kühlfluid aus einer außen angeordneten Versorgungsquelle strömt durch eine Öffnung in der frontseitigen Halterungsplatte in einen der beidseitigen Hohlräume und durch die Zwischenräume und gelangt über den zweiten der beidseitigen Hohlräume und einer Öffnung in der rückseitigen Halterungsplatte aus dem System.

Die steigenden Leistungen der Prozessrechner und Server sind mit ständig steigenden Wärmeverlusten verbunden. So erreichen Hochleistungsprozessoren und Server, insbesondere die kompakten Bauformen von beispielsweise einer Höheneinheit (HE) wie Pizzabox- und Blade-Server, erhebliche Verlustleistungen. Die Abführung der freigesetzten Wärmemengen ist insbesondere bei Rechenzentren, welche in der Regel eine relativ große Anzahl von Serverschränken in einem Raum aufweisen, mit ständig steigenden Investitions- und Betriebskosten für die Klimatisierung des Raumes und die Kühlung der Schränke und der darin angeordneten elektronischen Ausrüstungen verbunden.

Diese elektronischen Ausrüstungen, beispielsweise Server, CPU's und dergleichen, werden häufig in Modulbauweise in einem standardisierten Gehäuse untergebracht und in aller Regel übereinander, aber auch nebeneinander in einem Geräte- bzw. Netzwerkschrank an entsprechend angeordneten Vertikalholmen montiert. Um die entstehende Wärme abführen zu können, sind diese elektronischen Moduleinheiten mit wenigstens einem Lüfter sowie Lufteintritts- und Luftaustrittsöffnungen versehen, welche in den Seitenwänden oder in der Front- und Rückseite des Gehäuses angeordnet sein können.

Besonders in den kompakten Serverbauformen sind Kühlflächen für eine Luftkühlung nicht mehr unterzubringen. Außerdem reichen die Klimatisierungsanlagen von mit Luft klimatisierten Räumen für Anordnungen von Schränken, welche mit dicht gepackten Moduleinheiten versehen sind und Wärmebelastungen von 10 kW und mehr pro Schrank aufweisen können, nicht mehr aus, den Wärmestrom aufzunehmen.

In der Regel sind luftgekühlte Serverschränke mit perforierten Türen versehen, um eine möglichst große Luftdurchlässigkeit zu erreichen. Es ist außerdem bekannt, zur Kühlung von geschlossenen Innenräumen von Geräteschränken Luft-Wasser-Wärmetauscher einzusetzen (knurr-Katalog "Electronic Systems" 07/2002, Seiten 252 bis 254). Die bekannten Luft-Wasser-Wärmetauscher können auf der Schrankabdeckung oder an einem Außenbereich einer Seitenwand oder einer rückseitigen Tür montiert oder auch als Einschub angeordnet sein, und die Schrankinnentemperatur kann bis unter die Umgebungstemperatur abgekühlt werden.

Ein Nachteil ist die Belegung von Innenraum, welcher damit für die Bestückung mit Moduleinheiten nicht mehr zur Verfügung steht. Bei Anordnung der Luft-Wasser-Wärmetauscher an einer Seitenwand werden eine Aneinanderreihung von Schränken und eine rationelle Ausnutzung des zur Verfügung stehenden Aufstellungsraumes eingeschränkt. Die Anordnung auf der Schrankabdeckung kann im Falle eines Wasseraustritts zur Beschädigung der elektronischen Moduleinheiten und dergleichen führen. Des weiteren ist eine gleichmäßige Kühlung der Moduleinheiten aufgrund der Luftführung nicht immer gewährleistet.

Aus US 6,506,111 B2, US 6,652,373 B2, WO 03/005791 A2 und US 6,652,374 B2 sind Serverschränke für übereinander angeordnete Server bekannt, deren Verlustwärme durch einen rezirkulierenden Luftstrom abgeführt wird. Ein von den Servern erwärmter Abluftstrom wird mit Hilfe einer Ventilatoranordnung einem nachgeordneten Luft-Wasser-Wärmetauscher, welcher unterhalb des Schrankes in einem Sockel oder innerhalb des Schrankes unter der Server-Stapelanordnung angeordnet ist, zugeführt und gelangt als abgekühlte Zuluft über einen Zuluftkanal zu den Servern.

Eine Verbesserung der Wärmeabführung soll durch wenigstens eine Luftverteilungseinrichtung erreicht werden, welche insbesondere im Zuluftkanal, aber auch im Abluftkanal oder jeweils im Zu- und Abluftkanal angeordnet wird. Die Luftvereteilungseinrichtung soll sichern, dass den einzelnen Servern ein vorbestimmbarer Anteil des Luftstroms zugeführt wird. Im Wesentlichen handelt es sich um ein Blech, welches über die Stapelanordnung der Server reicht und mit Luftdurchtrittsöffnungen versehen ist, welche in horizontalen Reihen komplementär zu den Zwischenräumen zwischen den Servern ausgebildet sind. Um über die Schrankhöhe allen Servern eine nahezu gleiche Luftmenge zuzuführen, weist das Luftverteilerblech nahe dem Schranksockel bzw. dem Wärmetauscher keine oder nur wenige Luftdurchtrittsöffnungen und in einem oberen Bereich mehrere Reihen mit über die gesamte Breite angeordneten Luftdurchtrittsöffnungen auf.

In einer alternativen Ausbildung soll eine nahezu gleiche Luftzuteilung zu den Servern mittels eines Luftverteilerbleches erreicht werden, welches schräg im Zuluftkanal angeordnet ist, so dass der Querschnitt des Zuluftkanals nach oben abnimmt. Das Luftverteilerblech wird insbesondere an der Fronttür des Schrankes befestigt, und die Schrägstellung kann mit Hilfe eines Scharniers am unteren Ende sowie Befestigungslaschen mit Langlöchern am oberen Ende variiert werden.

Das bekannte Wärmeabführungssystem erfordert zusätzliche Aufwendungen für Konstruktion, Fertigung und Montage der wenigstens einen Luftverteilungseinrichtung. Außerdem kann die angestrebte einheitliche Luftzuteilung und gleichmäßige Wärmeabführung wegen der erreichten Luftführung nicht im erforderlichen Umfang gewährleistet werden.

Der Erfindung liegt die **Aufgabe** zugrunde, ein Kühlungssystem für Geräte- und Netzwerkschränke, insbesondere Serverschränke, und ein Verfahren zur Kühlung derartiger Schränke und der darin angeordneten Moduleinheiten, insbesondere Server, zu schaffen, welche mit außerordentlich einfachen Mitteln und besonders geringen Investitions- und Betriebskosten eine erforderliche Kühlleistung für dicht gepackte Schränke und Schrankanordnungen, insbesondere für Hochleistungsserver, mit der notwendigen Sicherheit gewährleisten.

In Bezug auf das Kühlsystem wird die Aufgabe erfindungsgemäß durch die Merkmale des Anspruchs 1 und in Bezug auf das Kühlverfahren durch die Merkmale des Anspruchs 17 gelöst. Zweckmäßige und vorteilhafte Ausgestaltungen sind in den jeweiligen Unteransprüchen und in der Figurenbeschreibung beschrieben.

Das erfindungsgemäße Kühlungssystem geht von einem geschlossenen Kühlluftkreislauf in einem weitgehend luftdichten Netzwerk- bzw. Geräteschrank und von einem Luft-Wasser-Wärmetauscher aus, mit welchem die Abführung der gesamten Verlustleistung erfolgt. Der Luft-Wasser-Wärmetauscher ist in einem unteren Bereich des Schrankes angeordnet und vorteilhaft an die Kaltwasserversorgung des Gebäudes angeschlossen.

Nach einem Grundgedanken der Erfindung weist das Kühlungssystem eine Luftführung mit gleich langen Luftwegen und damit gleichen Strömungswiderständen für die einzelnen elektronischen Moduleinheiten im Schrankinnenraum auf (Tichlmann-Prinzip). Auf diese Weise kann jeder der einzelnen Moduleinheiten, welche über- und/oder nebeneinander angeordnet sind, Zuluft mit einer einheitlichen Zulufttemperatur zugeführt werden. Die einheitliche Zulufttemperatur kann vorzugsweise durch eine entsprechend hohe Strömungsgeschwindigkeit unterstützt werden, wobei unter einer einheitlichen Zulufttemperatur eine Temperatur mit etwa +/-2 Kelvingraden verstanden werden soll.

Erfindungsgemäß ist eine lufttechnische Trennung der kalten Zuluft von der erwärmten Abluft vorgesehen.

Der weitgehend luftdichte Netzwerkschrank kann beispielsweise nahezu vollständig gegen die Umgebung abgedichtet sein und einem IP-Schutzwert von beispielsweise IP 55 genügen, d.h. staub- und strahlwasserdicht ausgebildet sein. Aufgrund der Abdichtung ist ein Luftaustausch zwischen dem Schrankinnenraum und dem Aufstellungsraum, in welchem in der Regel mehrere derartiger Schränke aufgestellt sind, verhindert und die Anforderungen an die Raumklimatisierung, welche zu erheblichen Kosten führen, können entfallen.

Bei der Zuluft handelt es sich um Kaltluft bzw. gekühlte Luft aus dem Luft-Wasser-Wärmetauscher im unteren Bereich des Schrankes. Diese Zuluft wird über einen Zuluftkanal des Schrankes, welcher über die gesamte Schrankhöhe reichen kann, zumindest jedoch im Bereich der Moduleinheiten ausgebildet ist, den Moduleinheiten und Zwischenräumen zwischen den Moduleinheiten zugeführt.

Die Gehäuse der Moduleinheiten weisen zweckmäßigerweise Lufteintrittsöffnungen auf, welche mit dem Zuluftkanal in Verbindung stehen. Die gekühlte Zuluft gelangt durch die Lufteintrittsöffnungen in die Moduleinheiten, wird durch die aufgenommene Verlustwärme erwärmt und gelangt über Luftaustrittsöffnungen, welche vorzugsweise in einer Gehäusewand parallel zu den Lufteintrittsöffnungen ausgebildet sind, in einen Abluftkanal.

In den Moduleinheiten kann wenigstens ein Lüfter angeordnet sein, welcher die kalte Zuluft z.B. ansaugt und durch die Luftaustrittsöffnungen in den Abluftkanal führt. Grundsätzlich gewährleistet jedoch die erfindungsgemäße Luftführung eine gleichmäßige Kühlung von Moduleinheiten auch ohne Lüfter. Das erfindungsgemäße Kühlungssystem hat somit den Vorteil, dass die Moduleinheiten ohne Lüfter in der erforderlichen Weise gekühlt werden können.

Der Abluftkanal ist zur Realisierung der für alle Moduleinheiten gleich langen Luftwege und gleichen Luftwiderstände geteilt ausgebildet und weist einen ersten Kanalabschnitt und einen zweiten, nachfolgenden Kanalabschnitt auf. Der erste Kanalabschnitt ist als ein Sammelkanal ausgebildet und nimmt die aus den Luftaustrittsöffnungen der Moduleinheiten austretende, erwärmte Abluft auf.

Es ist vorteilhaft, dass in dem Sammelkanal wenigstens von dem Raum hinter den Moduleinheiten gebildet werden kann, welcher in aller Regel zur Kabelführung genutzt wird. In den Sammelkanal werden die Abluftströme der einzelnen Moduleinheiten in einer aufsteigenden Abluftströmung mit Hilfe wenigstens eines Ventilators gesammelt, nach oben geführt, umgelenkt und in den zweiten Kanalabschnitt in einer parallelen, absteigenden Abluftströmung dem in einem unteren Schrankbereich angeordneten Luft-Wasser-Wärmetauscher zugeführt.

Es ist von Vorteil, dass mindestens zwei oder n+1 redundante, leistungsstarke Ventilatoren im oberen Schrankbereich vorgesehen werden können, um die erfindungsgemäße Luftführung des geschlossenen Kühlluftkreislaufes zu gewährleisten.

Zweckmäßigerweise sind die Ventilatoren nebeneinander angeordnet, und der absteigende Kanalabschnitt ist mit Hilfe eines vertikalen Trennelementes, z.B. eines Trennsteges, in einzelne Abluftkanalabschnitte, z.B. in einen rechten und linken Abluftkanalabschnitt, geteilt. Bei Ausfall eines Ventilators wird dadurch eine Rückströmung verhindert.

In einer bevorzugten Ausbildung sind die Ventilatoren und der zweite Kanalabschnitt für die absteigende Abluftströmung in eine Tür, insbesondere in die rückseitige Tür, integriert.

Die Anordnung des Zuluftkanals und des Abluftkanals mit dem ersten und zweiten Kanalabschnitt erfolgt entsprechend der Luftführung in den Moduleinheiten. In der Regel sind eine frontseitige Ansaugung der gekühlten Zuluft und eine rückseitige Abluftströmung der erwärmten Abluft vorgesehen. Entsprechend ist der Zuluftkanal frontseitig und der geteilte Abluftkanal rückseitig bzw. mit den Ventilatoren und dem zweiten Kanalabschnitt in einer rückseitigen Tür ausgebildet.

Es liegt im Rahmen der Erfindung, den Zuluftkanal und den Abluftkanal auch umgekehrt oder im Bereich der Seitenwände anzuordnen.

Die lufttechnische Trennung der kalten Zuluft von der erwärmten Abluft, welche zur Realisierung der angestrebten Hochleistungskühlung beiträgt, kann vorteilhaft mit Trennwänden, welche zwischen den Moduleinheiten und den Schrankwänden angeordnet werden, und/oder mit Blindplatten im frontseitigen Bereich der Moduleinheiten erreicht werden. Es wird dann eine Zuführung der kalten Zuluft allein in die Moduleinheiten und deren horizontalen Zwischenräume gewährleistet.

Zur Aufrechterhaltung der Luftzirkulation und des Regelkreises im Falle einer Störung, d.h. bei Ausfall aller Moduleinheiten, ist eine gezielte Unterbrechung bzw. "Leckage", insbesondere im oberen Schrankbereich, vorteilhaft vorzusehen.

Es ist vorteilhaft, dass ein an sich bekannter Luft-Wasser-Wärmetauscher eingesetzt werden kann, welcher nur entsprechend dimensioniert ist, beispielsweise über die gesamte Breite und/oder Tiefe des Schrankes reichen kann. Um die im zweiten Kanalabschnitt nach unten gedrückte Abluft aufnehmen zu können, zu kühlen und als gekühlte Zuluft dem Zuluftkanal wieder zuzuführen, ist es zweckmäßig, die unteren Abluftöffnungen des zweiten Kanalabschnittes komplementär zu den Eintrittsöffnungen des Luft-Wasser-Wärmetauschers auszubilden und mit einer entsprechenden Abdichtung zu versehen.

Es ist von Vorteil, dass der Luft-Wasser-Wärmetauscher innerhalb des Schrankes angeordnet wird und beispielsweise die untersten sechs Höheneinheiten (HE) belegen kann. Es sind dann kurze Kaltwasserleitungswege zum Anschluss an die Kaltwasserversorgung des Gebäudes erforderlich. Besonders vorteilhaft ist die untere Anordnung auch in Bezug auf die Sicherheit der elektronischen Moduleinheiten und weiterer elektrischer und elektronischer Geräte und Bauteile bei eventuellen Undichtigkeiten im Kaltwassersystem. Da eventuell austretendes Wasser auf keinen Fall in den Bereich der elektrischen Moduleinheiten oberhalb des Luft-Wasser-Wärmetauschers gelangen kann, ist die erforderliche Sicherheit gewährleistet.

Der Luft-Wasser-Wärmetauscher wird sinnvollerweise entsprechend der erforderlichen Kühlleistung ausgelegt. Bei einer 20 kW Kühlleistung können z.B. als Mengenströme 1 1/s Kaltwasser und 4000m³/h umgewälzte Kühlluft vorgesehen sein. Es ist auch vorteilhaft, dass der Vorlauf und Rücklauf des Kaltwassers des Luft-Wasser-Wärmetauschers so ausgelegt werden kann, dass eine Taupunktunterschreitung und damit eine Kondensatbildung im Schrank ausgeschlossen werden kann.

Es ist zweckmäßig, DC-Ventilatoren in n+1-Redundanz vorzusehen. Wenn diese Ventilatoren temperaturabhängig, drehzahlgeregelt und alarmüberwacht ausgebildet sind, kann mittels dieser Regelung und einer Software die Temperatur-Drehzahlkennlinie der tatsächlichen maximalen Verlustleistung der Moduleinheiten, beispielsweise Server, angepasst werden.

Ein variabler Volumenstrom dient der Anpassung der Entwärmungsleistung des Schrankes an die tatsächliche Verlustleistung der Moduleinheiten bzw. Server, die je nach Rechenleistung und Auslastung variieren kann.

Zweckmäßig ist außerdem eine Ausrüstung mit einem Schranküberwachungssystem, an welches unter anderem ein Rauchmelder, ein Türkontaktschalter, ein Feuchtesensor, ein Wasserdetektor und eine Drehzahlregelung angeschlossen sein können. Mit Hilfe von Temperatursensoren kann außerdem die Zulufttemperatur zu den Moduleinheiten überwacht und bei einer Überschreitung frei programmierbarer Sollwerte können verschiedene Alarmstufen (nicht dringend, dringend) ausgelöst und bei einer thermischen Gefahr die AC-Stromversorgung der Moduleinheiten automatisch unterbrochen werden.

Zweckmäßigerweise ist vorgesehen, dass bei einer Öffnung der rückseitigen Tür die Ventilatoren automatisch abgeschaltet werden. Bei geschlossener Rücktür gehen diese wieder in Betrieb.

Vorteilhaft ist die Ausrüstung des Schrankes mit einer eigenen n+1-redundanten DC-Stromversorgung für die Ventilatoren. Über eine AC-Verteilung werden die Steckdosenleisten zur AC-Einspeisung der Moduleinheiten, insbesondere Server, abgesichert und geschaltet.

Gemäß dem erfindungsgemäßen Verfahren wird den einzelnen Moduleinheiten, welche in einem weitgehend luftdichten Geräte- und Netzwerkschrank neben- und/oder übereinander angeordnet und mit einem in einem geschlossenen Kreislauf geführten Luftstrom gekühlt werden, kalte Zuluft in gleich langen Luftwegen und damit gleichen Strömungswiderständen sowie mit einer einheitlichen Zulufttemperatur zugeführt, und die kalte Zuluft wird von der erwärmten Abluft lufttechnisch getrennt.

Es ist zweckmäßig, die in einem Zuluftkanal und Abluftkanal geführte Luft in dem weitgehend luftdichten Schrank mit einer relativ hohen Geschwindigkeit im Kreislauf zu führen. Hierzu werden vorzugsweise n+1-redundante und leistungsstarke Ventilatoren definiert in einem auf- und absteigenden Abluftstrom positioniert.

Der Luftstrom wird dabei mit Hilfe eines Luft-Wasser-Wärmetauschers, der in einem unteren Schrankbereich angeordnet wird, gekühlt. Der in diesem Luft-Wasser-Wärmetauscher gekühlte Zuluftstrom wird den einzelnen Moduleinheiten, beispielsweise über deren Lufteintrittsöffnungen, zugeführt, nimmt die in den Moduleinheiten erzeugte Verlustwärme auf und gelangt mit Hilfe der nachgeordneten Ventilatoren in den Abluftkanal.

Zweckmäßigerweise ist der Abluftkanal zur Realisierung des Tichlmann-Prinzips, d.h. gleicher Strömungswege und gleicher Strömungswiderstände, geteilt ausgebildet. In einem Sammelkanal wird die Abluft der einzelnen Moduleinheiten zunächst in einer aufsteigenden Strömung geführt. Indem die Abluft in dieser aufsteigenden Strömung dem thermischen Auftrieb folgt, wird vorteilhafterweise eine verbesserte Energiebilanz erreicht. Nach einer Umlenkung des aufsteigenden Abluftstromes wird die Abluft einer absteigenden Strömung unterworfen und dem Luft-Wasser-Wärmetauscher im unteren Schrankbereich zugeführt.

Mit der relativ hohen Strömungsgeschwindigkeit wird durch das Luftführungskonzept und der lufttechnischen Trennung der Zuluft-/Abluftströmung in Verbindung mit dem unteren Luft-Wasser-Wärmetauscher eine effiziente Kühlung der Moduleinheiten erreicht.

Es ist vorteilhaft, wenn zur lufttechnischen Trennung der kalten Zuluft von der erwärmten Abluft neben vertikalen Trennelementen zwischen den über- und/oder nebeneinander angeordneten Moduleinheiten Blindplatten an frei bleibenden Positionen angeordnet werden.

Das erfindungsgemäße Kühlungssystem für Netzwerkschränke, insbesondere Serverschränke, ermöglicht mit relativ geringen Investitions- und Betriebskosten eine Hochleistungskühlung, insbesondere für Schränke in kommerziellen Rechenzentren, z.B. im Banken- und Industriebereich, aber auch im Wissenschaftsbereich und bei Rechner-Clustern, welche beispielsweise bis zu 100 Schränke zu je 10 kW aufweisen können. Insbesondere können wassergekühlte Serverschränke bis beispielsweise 20 kW und mehr Kühlleistung in beispielsweise 2,5 kW.

Schritten abgestuft geschaffen werden und in diesen Schränken eine gleichmäßige Kühlluftversorgung aller Server unabhängig von der Einbauposition im Schrank gewährleistet werden. Der Einbau von Lüftern in die Moduleinheiten ist nicht unbedingt erforderlich, da das erfindungsgemäße Kühlungskonzept eine gleichmäßige Kühlung der einzelnen Moduleinheiten auch ohne Lüfter sichert.

Eine Überhitzung und ein Ausfall der Server und die damit verbundenen erheblichen Kosten, werden vermieden und eine hohe Verfügbarkeit gesichert.

Vorteilhaft ist außerdem die Unabhängigkeit des erfindungsgemäßen Schrank-Kühlungssystems von der Raumluft. Dadurch wird eine hohe Bestückung mit Schränken in einem Raum möglich, und voll bestückte Schränke können relativ dicht aufgestellt werden, wodurch gegenüber der konventionellen Raumklimatisierung eine erhebliche Flächeneinsparung erreicht werden kann. Es ist außerdem von Vorteil, dass in Rechenzentren mit einer konventionellen Raumklimatisierung einzelne Schränke, welche eine vergleichsweise hohe Verlustwärme aufweisen, mit dem erfindungsgemäßen Kühlungssystem ausgestattet werden können. Die Raumklimatisierung kann dann Kosten sparend an die geringere Verlustwärme der übrigen Schränke angepasst werden.

Die Erfindung wir nachstehend anhand einer Zeichnung erläutert. In dieser zeigen in einer stark schematisierten Weise
- Fig. 1: einen Längsschnitt durch einen Netzwerkschrank mit dem erfindungsgemäßen Kühlungssystem und
- Fig. 2: einen Querschnitt durch den Netzwerkschrank nach Fig. 1.

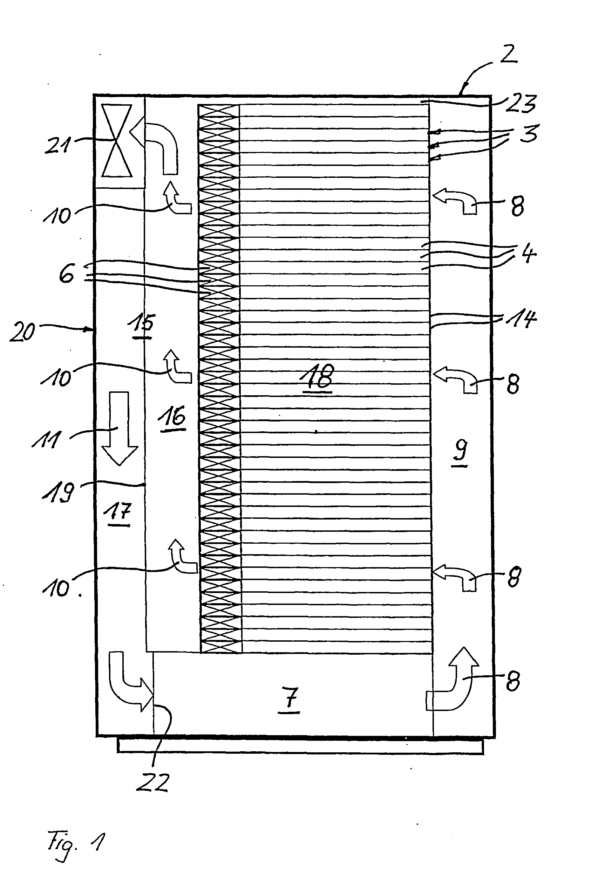

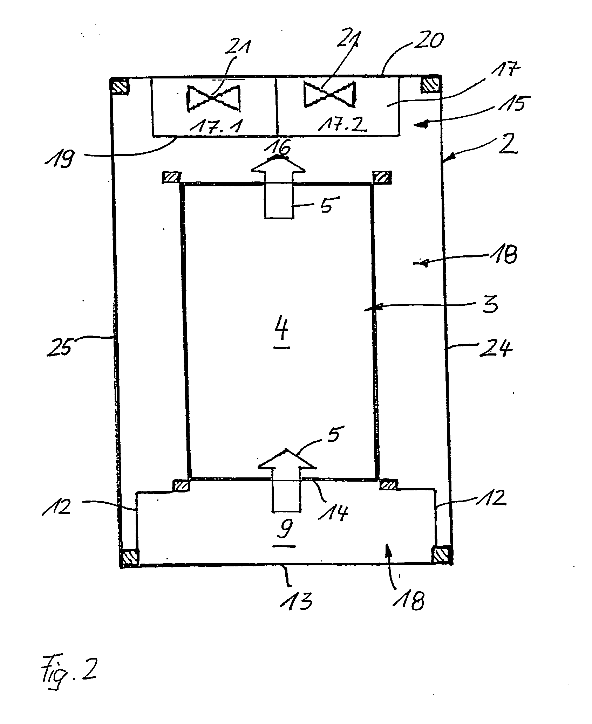

Fig. 1 zeigt einen Geräte- bzw. Netzwerkschrank 2 mit einem abgedichteten Innenraum 18 und übereinander angeordneten elektronischen Moduleinheiten 3. Der Geräte- und Netzwerkschrank 2 ist in diesem Ausführungsbeispiel ein Serverschrank, und die elektronischen Moduleinheiten 3 sind z.B. Server 4 von z.B. einer Höheneinheit (1 HE=44,45 mm=1,75 inch). Die Luftführung 5 im Bereich der Server 4 wird durch Pfeile verdeutlicht (Fig. 2). In diesem Ausführungsbeispiel ist innerhalb der Gehäuse der Server 4 jeweils ein Lüfter 6 angeordnet, welcher die Luftführung 5 bewerkstelligt, d.h. Zuluft 8 über frontseitige Lufteintrittsöffnungen (nicht dargestellt) ansaugt, über die Verlustwärme erzeugenden, elektronischen Bauteile (nicht dargestellt) führt und über rückseitige Luftaustrittsöffnungen (nicht dargestellt) einem Abluftkanal 15 zuführt.

Unterhalb der Server 4 ist ein Luft-Wasser-Wärmetauscher 7 angeordnet, welcher an die Kaltwasserversorgung des Gebäudes angeschlossen ist und beispielsweise 6 HE benötigen kann. Bei einem Serverschrank mit 46 HE stehen somit 40 HE für die Server 4 zur Verfügung.

Der Luft-Wasser-Wärmetauscher 7 kann beispielsweise mit einer Kaltwassermenge von 1 1/s und einer Zulauftemperatur von etwa 12°C betrieben werden, wodurch eine in einem geschlossenen Kreislauf geführte, auf etwa 35°C erwärmte Abluft 10, 11 auf ca. 20 bis 25°C abgekühlt werden kann. Die im Luft-Wasser-Wärmetauscher 7 abgekühlte Luft wird als Zuluft 8 einem Zuluftkanal 9 zugeführt, welcher mit den Lufteintrittsöffnungen (nicht dargestellt) der Server 4 in Verbindung steht.

Fig. 2 zeigt die lufttechnische Trennung zwischen der kalten Zuluft 8 und der in den Servern 4 erwärmten Abluft im Abluftkanal 15. Die lufttechnische Trennung erfolgt im frontseitigen Bereich des Netzwerkschrankes 2 mit Hilfe von Trennwänden 12, welche als abgewinkelte Bleche ausgebildet und vertikal angeordnet sind. Durch die Trennwände 12, eine dicht schließende Fronttür 13 und Gehäusefrontseiten 14 der Server 4 wird der Zuluftkanal 9 begrenzt.

Gemäß Fig. 1 sind alle vorhandenen HE des Schrankes 2 oberhalb des Luft-Wasser-Wärmetauschers 7 mit Servern 4 besetzt, weshalb Blindplatten für nicht besetzte HE nicht erforderlich sind.

Die Abluft 10, 11 gelangt in einen Abluftkanal 15, welcher einen ersten, als Sammelkanal 16 ausgebildeten Kanalabschnitt für eine aufsteigende Abluftströmung 10 und einen zweiten Kanalabschnitt 17 für eine absteigende Abluftströmung 11 aufweist.

Der zweite Kanalabschnitt 17 für die absteigende Abluftströmung 11 ist an einer rückseitigen Tür 20 ausgebildet, welche eine innenseitige Türabdeckung 19 und außerdem zum Ansaugen der Abluft 10 mit zwei Ventilatoren 21 versehen ist. Die Ventilatoren 21 sind im oberen Bereich und in gleicher Höhe sowie nebeneinander angeordnet, und die umgelenkte Abluft 11 wird in einem rechten und linken, jedem Ventilator 21 zugeordneten Kanal 17.1, 17.2 über untere Abluftöffnungen 22 dem Luft-Wasser-Wärmetauscher 7 aufgegeben.

Fig. 2 zeigt, dass der Sammelkanal 16 für die erwärmte Abluft 10 nicht nur hinter den Servern 4, sondern auch seitlich von diesen im Bereich der Seitenwände 24, 25 des Schrankes 2 ausgebildet sein kann, wenn die lufttechnische Trennung von Zuluft und Abluft vorteilhaft im frontseitigen Bereich durchgeführt wird.

Fig. 1 verdeutlicht die gleich langen Luftwege und gleichen Strömungswiderstände unabhängig von der Einbauhöhe der Server 4 aufgrund der Anordnung des Luft-Wasser-Wärmetauschers 7 unterhalb der Server 4 und aufgrund der Luftführung, insbesondere in den aufsteigenden und absteigenden Kanalabschnitten 16, 17 des Abluftkanals 15. Mit Hilfe der auf- und absteigenden Abluft 10, 11 in dem geteilten Abluftkanal 15 wird eine unmittelbare Beaufschlagung des Luft-Wasser-Wärmetauschers 7 mit der erwärmten Abluft verhindert.

Eine kleine, gezielte Unterbrechung 23 der Lufttrennung zwischen der kalten bzw. abgekühlten Zuluft 8 und der erwärmten Abluft 10 dient der Aufrechterhaltung der Zirkulation des Luftstromes und damit der Aufrechterhaltung des Regelkreises, auch bei Ausfall der Moduleinheiten bzw. der Server. Diese gezielte Unterbrechung bzw. bzw. "Leckage" 23 ist im oberen Bereich des Schrankes 2, insbesondere oberhalb der Moduleinheiten 3, vorgesehen.

## Patentansprüche

1. Kühlungssystem für Geräte- und Netzwerkschränke
mit einem abgedichteten Innenraum (18), in welchem elektronische Moduleinheiten (3) übereinander angeordnet sind, einem geschlossenen Kühlluftkreislauf zur Abführung der Verlustwärme der elektronischen Moduleinheiten (3) und einem Luft-Wasser-Wärmetauscher (7) zur Abkühlung der erwärmten Abluft des Kühlluftkreislaufs, welcher in einem unteren Bereich des Schrankes (2) angeordnet und mit einem Zuluftkanal (9) und Abluftkanal (15) verbunden ist,
**dadurch gekennzeichnet,**
**dass** der Abluftkanal (15) einen ersten Kanalabschnitt (16) für einen aufsteigenden Abluftstrom (10) und einen zweiten Kanalabschnitt (17) für einen absteigenden Abluftstrom (11) aufweist und eine Luftführung mit gleich langen Luftwegen und damit gleichen Strömungswiderständen für die einzelnen Moduleinheiten (3) sowie eine lufttechnische Trennung zwischen der kalten Zuluft (8) und der erwärmten Abluft (9) vorgesehen ist und dass den einzelnen Moduleinheiten (3) kalte Zuluft (8) mit einer einheitlichen Zulufttemperatur zuführbar ist.

2. Kühlungssystem nach Anspruch 1,
**dadurch gekennzeichnet,**
**dass** die einheitliche Zulufttemperatur unabhängig von der Einbauposition der elektronischen Moduleinheiten (3) durch eine relativ hohe Strömungsgeschwindigkeit gesichert ist.

3. Kühlungssystem nach Anspruch 1 oder 2,
**dadurch gekennzeichnet,**
**dass** die kalte Zuluft (8) im Zuluftkanal (9) den elektronischen Moduleinheiten (3) über Lufteintrittsöffnungen der elektronischen Moduleinheiten (3) zuführbar ist.

4. Kühlungssystem nach einem der vorhergehenden Ansprüche,
**dadurch gekennzeichnet,**
**dass** die erwärmte Abluft (10, 11) über Luftaustrittsöffnungen der elektronischen Moduleinheiten (3) dem ersten Kanalabschnitt (16) des Abluftkanals (15) zuführbar ist.

5. Kühlungssystem nach einem der Ansprüche 3 oder 4,
**dadurch gekennzeichnet,**
**dass** der Zuluftkanal (9) und der Abluftkanal (15) in Übereinstimmung mit den frontseitigen Lufteintrittsöffnungen und rückseitigen Luftaustrittsöffnungen der elektronischen Moduleinheiten (3) ausgebildet sind.

6. Kühlungssystem nach einem der vorhergehenden Ansprüche,
**dadurch gekennzeichnet,**
**dass** der Zuluftkanal (9) und der Abluftkanal (15) nahezu über die gesamte Schrankhöhe ausgebildet sind.

7. Kühlungssystem nach einem der Ansprüche 4 bis 6,
**dadurch gekennzeichnet,**
**dass** die lufttechnische Trennung der kalten Zuluft (8) und der erwärmten Abluft (10, 11) mit Hilfe von Trennwänden (12) zwischen den elektronischen Moduleinheiten (3) und einem Schrankverkleidungsteil, beispielsweise einer Fronttür (13), und/oder Blindplatten zwischen über- und/oder nebeneinander angeordneten Moduleinheiten (3) ausgebildet ist.

8. Kühlungssystem nach einem der vorhergehenden Ansprüche,
**dadurch gekennzeichnet,**
**dass** der erste Kanalabschnitt (16) für die aufsteigende Abluft (10) als Sammelkanal für die aus den elektronischen Moduleinheiten (3) austretende, erwärmte Abluft ausgebildet und hinter den elektronischen Moduleinheiten (3) im Bereich der Kabelführungen angeordnet ist.

9. Kühlungssystem nach einem der vorhergehenden Ansprüche,
**dadurch gekennzeichnet,**
**dass** der im ersten Kanalabschnitt (16) aufsteigende Abluftstrom (10) mit Hilfe wenigstens eines Ventilators (21) nach oben geführt und nach einer Umlenkung in dem zweiten Kanalabschnitt (17) als absteigende Abluftströmung (11) dem Luft-Wasser-Wärmetauscher (7) zuführbar ist.

10. Kühlungssystem nach Anspruch 9,
**dadurch gekennzeichnet,**
**dass** zwei oder mehr redundante Ventilatoren (21) in einer rückseitigen Tür (20) angeordnet sind und dass die absteigende Abluft (11) in einem rechten und linken Kanalabschnitt (17.1, 17.2) nach unten geführt und dem Luft-Wasser-Wärmetauscher (7) über untere Abluftöffnungen (22) zuführbar ist.

11. Kühlungssystem nach Anspruch 10,
**dadurch gekennzeichnet,**
**dass** der rechte und linke Kanalabschnitt (17.1, 17.2) durch eine innenseitige Abdeckung (19) der rückseitigen Tür (20) und einen vertikalen Trennsteg (23) gebildet sind.

12. Kühlungssystem nach Anspruch 11,
**dadurch gekennzeichnet,**
**dass** die innenseitige Türabdeckung (19), zumindest im Bereich der unteren Abluftöffnungen (22) bis an den Luft-Wasser-Wärmetauscher (7) reicht und abgedichtet ist.

13. Kühlungssystem nach einem der vorhergehenden Ansprüche,
**dadurch gekennzeichnet,**
**dass** der Luft-Wasser-Wärmetauscher (7) im Bereich der untersten Höheneinheiten angeordnet und entsprechend der Breite und/oder Tiefe des Schrankes (2) dimensioniert ist.

14. Kühlungssystem nach einem der vorhergehenden Ansprüche,
**dadurch gekennzeichnet,**
**dass** der Luft-Wasser-Wärmetauscher (7) an die Kaltwasserversorgung des Gebäudes anschließbar ist.

15. Kühlungssystem nach einem der vorhergehenden Ansprüche,
**dadurch gekennzeichnet,**
**dass** die Ventilatoren (21) im Bereich des Abluftkanals (15) temperaturabhängig, drehzahlgeregelt und alarmüberwacht sind und an die tatsächliche Verlustleistung der einzelnen elektronischen Moduleinheiten (3) anpassbar sind.

16. Kühlungssystem nach einem der vorhergehenden Ansprüche,
**dadurch gekennzeichnet,**
**dass** der Schrank (2) ein Serverschrank ist und die übereinander angeordneten elektronischen Moduleinheiten (3) Server (4), beispielsweise mit einer kompakten Bauform von 1 HE, sind.

17. Verfahren zur Kühlung von Geräte- und Netzwerkschränken und darin angeordneter elektronischer Moduleinheiten, bei welchem ein Luftstrom in einem geschlossenen Kreislauf geführt wird, wobei kalte Zuluft den elektronischen Moduleinheiten zugeführt und erwärmte Abluft in einem Luft-Wasser-Wärmetauscher abgekühlt wird,
**dadurch gekennzeichnet,**
**dass** die kalte Zuluft von der erwärmten Abluft lufttechnisch getrennt wird und in gleich langen Luftwegen und damit gleichen Strömungswiderständen den einzelnen elektronischen Moduleinheiten kalte Zuluft zugeführt und erwärmte Abluft abgeführt wird, dass den elektronischen Moduleinheiten kalte Zuluft mit einer einheitlichen Zulufttemperatur zugeführt wird und die aus dem im unteren Schrankbereich angeordneten Luft-Wasser-Wärmetauscher austretende kalte Zuluft in einer aufsteigenden Zuluftströmung den übereinander angeordneten elektronischen Moduleinheiten zugeführt wird und dass die erwärmte Abluft aus den elektronischen Moduleinheiten zunächst in einem ersten Abluftkanalabschnitt gesammelt und einer aufsteigenden Strömung unterworfen, danach umgelenkt und in einer absteigenden Abluftströmung dem Luft-Wasser-Wärmetauscher im unteren Schrankbereich zugeführt wird.

18. Verfahren nach Anspruch 17,
**dadurch gekennzeichnet,**
**dass** die Luft in einem weitgehend luftdichten Schrank mit einer relativ hohen Geschwindigkeit im Kreislauf geführt wird.

19. Verfahren nach einem der Ansprüche 17 oder 18,
**dadurch gekennzeichnet,**
**dass** die im Kreislauf geführte Luft durch wenigstens einen Ventilator angetrieben wird und der Ventilator im Bereich der umgelenkten Abluftströmung angeordnet wird.

20. Verfahren nach einem der Ansprüche 17 bis 19,
**dadurch gekennzeichnet,**
**dass** die absteigende Abluftströmung in zwei parallelen Kanälen, insbesondere in der rückseitigen Tür, geführt wird und jedem Kanal ein Ventilator zugeordnet wird.

## Claims

1. Cooling system for instrument and network cabinets
with a sealed inner space (18) in which are located electronic modules (3) in superimposed manner, a closed cooling air circuit for dissipating the heat loss of the electronic modules (3) and an air-water heat exchanger (7) for cooling the heated cooling air circuit exhaust air, which is located in a lower area of the cabinet (2) and connected to a supply air duct (9) and exhaust air duct (15),
**characterized in that**
the exhaust air duct (15) has a first duct section (16) for a rising exhaust airflow (10) and a second duct section (17) for a falling exhaust airflow (11), and
an air ducting with equally long airflow paths and therefore equal flow resistances for the individual modules (3) as well as an air-technical separation between the cold supply air (8) and heated exhaust air (9) is provided and that the individual modules (3) can be supplied with cold supply air (8) at a uniform supply air temperature.

2. Cooling system according to claim 1,
**characterized in that**
the uniform supply air temperature is ensured by a relatively high flow rate independently of the installation position of the electronic modules (3).

3. Cooling system according to claim 1 or 2,
**characterized in that**
the cold supply air (8) in the supply air duct (9) can be supplied to the electronic modules (3) by means of air inlet ports therein.

4. Cooling system according to one of the preceding claims,
**characterized in that**
the heated exhaust air (10, 11) can be supplied by means of air outlet ports of the electronic modules (3) to the first duct section (16) of the exhaust air duct (15).

5. Cooling system according to one of the claims 3 or 4,
**characterized in that**
the supply air duct (9) and exhaust air duct (15) are constructed so as to coincide with the front air inlet ports and rear air outlet ports of the electronic modules (3).

6. Cooling system according to one of the preceding claims,
**characterized in that**
the supply air duct (9) and exhaust air duct (15) are formed virtually over the entire cabinet height.

7. Cooling system according to one of the claims 4 to 6,
**characterized in that**
the air separation of the cold supply air (8) and the heated exhaust air (10, 11) is brought about with the aid of partitions (12) between the electronic modules (3) and a cabinet covering part, e.g. a front door (13), and/or blind plates between superimposed and/or juxtaposed modules (3).

8. Cooling system according to one of the preceding claims,
**characterized in that**
the first duct section (16) for the rising exhaust air is constructed as a collecting duct for the heated exhaust air passing out of the electronic modules (3) and is located downstream of the electronic modules (3) in the vicinity of the cable runs.

9. Cooling system according to one of the preceding claims,
**characterized in that**
the exhaust air flow (10) rising in the first duct section (16) is guided upwards with the aid of at least one ventilator (21) and following a reversal in the second duct section (17) can be supplied as a falling exhaust airflow (11) to the air-water heat exchanger (7).

10. Cooling system according to claim 9,
**characterized in that**
two or more redundant ventilators (21) are provided in a rear door (20) and that the falling exhaust air (11) in a right and left-hand duct section (17.1, 17.2) is guided downwards and can be supplied by means of lower exhaust air openings (22) to the air-water heat exchanger (7).

11. Cooling system according to claim 10,
**characterized in that**
the right and left-hand duct sections (17.1, 17.2) are formed by an inside cover (19) of the rear door (20) and a vertical separating web (23).

12. Cooling system according to claim 11,
**characterized in that**
the inside door cover (19), at least in the vicinity of the lower exhaust air openings (22), extends up to the air-water heat exchanger (7) and is sealed.

13. Cooling system according to one of the preceding claims,
**characterized in that**
the air-water heat exchanger (7) is located in the area of the bottom height units and dimensioned in accordance with the width and/or depth of the cabinet (2).

14. Cooling system according to one of the preceding claims,
**characterized in that**,
the air-water heat exchanger (7) can be connected to the cold water supply of the building.

15. Cooling system according to one of the preceding claims,
**characterized in that**,
the ventilators (21) in the vicinity of the exhaust air duct (15) are temperature-dependent, speed-controlled and alarm-monitored and can be adapted to the actual power loss of the individual electronic modules (3).

16. Cooling system according to one of the preceding claims,
**characterized in that**
the cabinet (2) is a server cabinet and the superimposed electronic modules (3) are servers (4), e.g. with a compact design of 1 HU.

17. Method for cooling equipment and network cabinets and electronic modules located therein, in which an airflow travels in closed circuit form, cold supply air being supplied to the electronic modules and heated exhaust air is cooled in an air-water heat exchanger,
**characterized in that**,
the cold supply air is air-technically separated from the heated exhaust air and cold supply air is supplied and heated exhaust air removed in equally long airflow paths and therefore with equal flow resistances with respect to the individual electronic modules,
that cold supply air with a uniform supply air temperature is supplied to the electronic modules and
the cold supply air passing out of the air-water heat exchanger located in the lower cabinet area is supplied in a rising supply airflow to the individual superimposed electronic modules and that the heated exhaust air from the electronic modules is initially collected in a first exhaust air duct section and is subject to a rising flow, then reversed and supplied in a falling exhaust airflow to the air-water heat exchanger in the lower cabinet area.

18. Method according to claim 17,
**characterized in that**,
the air is circulated in a substantially airtight cabinet at a relatively high speed.

19. Method according to one of the claims 17 or 18,
**characterized in that**,
the circulated air is driven by at least one ventilator, and the ventilator is located in the area of the reversed exhaust airflow.

20. Method according to one of the claims 17 to 19,
**characterized in that**,
the falling exhaust airflow is ducted in two parallel ducts, particularly in the rear door and a ventilator is associated with each duct.

## Revendications

1. Système de refroidissement pour armoires d' appareillages et armoires de réseau comprenant un espace intérieur étanche (18), dans lequel des unités modulaires électroniques (3) sont superposées, un circuit fermé d'air de refroidissement pour évacuer la chaleur dissipée des unités modulaires électroniques (3) et un échangeur thermique air/eau (7) pour refroidir l'air échauffé d'échappement du circuit de refroidissement disposé dans une zone inférieure de l'armoire (2) et relié à un canal (9) d'air amené froid et à un canal (15) d'air d'échappement échauffé,
**caractérisé en ce que**
le canal d'air d'échappement échauffé (15) présente un premier segment (16) pour un flux ascendant (10) et un deuxième segment (17) pour un flux descendant (11), et un guidage d'air avec des trajets de même longueur et donc les mêmes résistances à l'écoulement pour les différentes unités modulaires (3) ainsi qu'une séparation aéraulique entre l'air d'amenée froid (8) et l'air échauffé d'échappement (9) sont prévus et **en ce que** les différentes unités modulaires (3) peuvent être alimentées en air d'amenée froid (8) à une température homogène.

2. Système de refroidissement selon la revendication 1,
**caractérisé en ce que**
la température homogène de l'air d'amenée est assurée indépendamment de la position de montage des unités modulaires électroniques (3) par une vitesse d'écoulement relativement élevée.

3. Système de refroidissement selon la revendication 1 ou 2,
**caractérisé en ce que**
dans le canal d'air amené (9) l'air d'amenée froid (8) peut être amené aux unités modulaires électroniques (3) par des ouvertures d'entrée d'air.

4. Système de refroidissement selon l'une quelconque des revendications précédentes,
**caractérisé en ce que**
l'air d'échappement échauffé (10, 11) peut être amené au premier segment (16) du canal d'air d'échappement (15) par des ouvertures de sortie d'air des unités modulaires électroniques (3).

5. Système de refroidissement selon l'une quelconque des revendications 3 ou 4,
**caractérisé en ce que**
le canal (9) d'air amené et le canal (15) d'air d'échappement sont formés en concordance avec les ouvertures d'entrée d'air côté frontal et les ouvertures de sortie d'air côté arrière des unités modulaires électroniques (3).

6. Système de refroidissement selon l'une quelconque des revendications précédentes,
**caractérisé en ce que**
le canal (9) d'air amené et le canal (15) d'air d'échappement sont formés sensiblement sur toute la hauteur de l'armoire.

7. Système de refroidissement selon l'une quelconque des revendications 4 à 6,
**caractérisé en ce que**
la séparation aéraulique de l'air d'amenée froid (8) et de l'air d'échappement échauffé (10, 11) est formée à l'aide de cloisons (12) entre les unités modulaires électroniques (3) et une partie d'habillage de l'armoire, par exemple une porte frontale (13), et/ou des plaques obturatrices disposées entres des unités modulaires (3) superposées et/ou juxtaposées.

8. Système de refroidissement selon l'une quelconque des revendications précédentes,
**caractérisé en ce que**
le premier segment de canal (16) pour l'air d'échappement ascendant (10) se présente sous la forme d'un canal collecteur d'air échauffé sortant des unités modulaires électroniques (3) et est disposé derrière les unités modulaires électroniques (3) dans la zone des conduites de câbles.

9. Système de refroidissement selon l'une quelconque des revendications précédentes,
**caractérisé en ce que**
dans le premier segment de canal (16) le flux d'air d'échappement ascendant (10) est guidé vers le haut à l'aide d'au moins un ventilateur (21) et peut être amené à l'échangeur thermique air/eau (7) sous forme de flux d'air d'échappement descendant (11) après une déviation dans le deuxième segment de canal (17).

10. Système de refroidissement selon la revendication 9,
**caractérisé en ce que**
deux ventilateurs redondants (21) ou plus sont disposés dans une porte arrière (20), et l'air d'échappement échauffé descendant (11), guidé vers le bas dans un segment de canal droit et gauche (17.1, 17.2), peut être amené à l'échangeur thermique air/eau (7) par des ouvertures inférieures (22).

11. Système de refroidissement selon la revendication 10,
**caractérisé en ce que**
les segments de canal droit et gauche (17.1, 17.2) sont formés par une couverture intérieure (19) de la porte arrière (20) et une nervure de séparation verticale (23).

12. Système de refroidissement selon la revendication 11,
**caractérisé en ce que**
la couverture de porte intérieure (19) s'étend, au moins dans la zone des ouvertures d'air d'échappement échauffé inférieures (22), jusqu'à l'échangeur thermique air/eau (7) et est étanche.

13. Système de refroidissement selon l'une quelconque des revendications précédentes,
**caractérisé en ce que**
l'échangeur thermique air/eau (7) est disposé dans la zone des unités de hauteur les plus faibles et dimensionné en fonction de la largeur et/ou de la profondeur de l'armoire (2).

14. Système de refroidissement selon l'une quelconque des revendications précédentes,
**caractérisé en ce que**
l'échangeur thermique air/eau (7) peut être raccordé à l'alimentation en eau froide du bâtiment.

15. Système de refroidissement selon l'une quelconque des revendications précédentes,
**caractérisé en ce que**
les ventilateurs (21) dans la zone du canal (15) d'air d'échappement échauffé sont dépendants de la température, ils sont régulés dans leur vitesse de rotation, surveillés par alarme et peuvent être adaptés à la puissance dissipée réelle des différentes unités modulaires électroniques (3).

16. Système de refroidissement selon l'une quelconque des revendications précédentes,
**caractérisé en ce que**
l'armoire (2) est une armoire serveur, et les unités modulaires électroniques (3) superposées sont des serveurs (4) d'une forme de construction compacte de 1 unité de hauteur HE.

17. Procédé de refroidissement d'armoires d'appareillages et d'armoires de réseau abritant des unités modulaires électroniques selon lequel un flux d'air est guidé dans un circuit fermé, de l'air d'amenée froid étant amené aux unités modulaires électroniques et de l'air d'échappement échauffé étant refroidi dans un échangeur thermique air/eau,
**caractérisé en ce que**
l'air d'amené froid et l'air d'échappement échauffé sont aérauliques, séparés et sur des trajets d'une même longueur et donc avec les mêmes résistances à l'écoulement, de l'air d'amenée froid est amené aux différentes unités modulaires électroniques et de l'air d'échappement échauffé est évacué, **en ce que** de l'air d'amenée froid est amené aux unités modulaires électroniques à une température homogène, et l'air d'amenée froid sortant de l'échangeur thermique air/eau disposé dans la zone d'armoire inférieure est amené dans un flux d'air d'amenée ascendant aux unités modulaires électroniques superposées, et l'air d'échappement échauffé des unités modulaires électroniques est d'abord accumulé dans un premier segment de canal d'air, d'échappement et soumis à un flux ascendant, puis dévié et amené dans un flux d'air d'échappement descendant à l'échangeur thermique air/eau dans la zone d'armoire inférieure.

18. Procédé selon la revendication 17,
**caractérisé en ce que**
l'air est guidé dans le circuit à une vitesse relativement élevée à l'intérieur d'une armoire pour l'essentiel étanche à l'air.

19. Procédé selon l'une quelconque des revendications 17 ou 18,
**caractérisé en ce que**
l'air guidé dans le circuit est entraîné par au moins un ventilateur et le ventilateur est disposé dans la zone du flux d'air d'échappement dévié.

20. Procédé selon l'une quelconque des revendications 17 à 19,
**caractérisé en ce que**
le flux d'air d'échappement descendant est guidé dans deux canaux parallèles, en particulier dans la porte arrière, et à chaque canal est associé un ventilateur.
